# EUROPEAN PATENT SPECIFICATION

(11) **EP 0 441 893 B1**
(45) Date of publication and mention of the grant of the patent: **24.05.1995**
(21) Application number: 90900507.6
(22) Date of filing: 06.10.1989
(51) Int. Cl.: C04B 35/00, C01G 21/00, H01L 39/12

(54) **SUPERCONDUCTING METAL OXIDE COMPOSITIONS AND PROCESSES FOR MANUFACTURE AND USE**
SUPERLEITFÄHIGE METALLOXIDZUSAMMENSETZUNGEN UND VERFAHREN ZUR HERSTELLUNG UND VERWENDUNG
COMPOSITIONS SUPRACONDUCTRICES D'OXYDE METALLIQUE, LEURS PROCEDES DE FABRICATION ET LEUR UTILISATION

(30) Priority: 26.10.1988 US 262776
(43) Date of publication of application: 21.08.1991
(73) Proprietor: E.I. DU PONT DE NEMOURS AND COMPANY, Wilmington Delaware 19898 (US)
(72) Inventor: GOPALAKRISHNAN, Jagannatha, Indian Inst. of Science Bangalore-560012 (IN); SUBRAMANIAN, Munirpallam, Appadorai, New Castle, DE 19720 (US)
(74) Representative: Jones, Alan John
(86) International application number: US8904297
(87) International publication number: WO9004573

(56) References cited:
- BEDNORZ et al, "Possible High TC Superconductivity in La-Ba-Cu-O System. Z Phys B64, 189 (1986).
- CHU et al, "Superconductivity at 52.5K in La-Ba-Cu-O System", Science 235, 587,(1987).
- RAO et al, "High TC Superconductivity in Quasi Two- Dimensional CuO of K2 Ni F Structure", Current Science 56, 47(1987).
- ENGLER et al, "Superconductivity above Liquid Nitrogen Temperatures:Preparation and Properties of a family of Perovskite-Based Superconductors", J.An Chem Soc, 109, 2848-49 (1987).
- CAVA et al, "Superconductivity near 70K in a new Family of layered copper oxides", Nature 336(6196), 211-14, (1988).

## Description

### BACKGROUND OF THE INVENTION

### Field of the Invention

This invention relates to novel superconducting Pb-R-Ca-Sr-Cu-O compositions where R is selected from the group consisting of yttrium and the lanthanides.

### References

Bednorz and Muller, Z. Phys. B64, 189(1986), disclose a superconducting phase in the La-Ba-Cu-O system with a superconducting transition temperature of about 35 K. This disclosure was subsequently confirmed by a number of investigators [see, for example, Rao and Ganguly, Current Science, 56, 47 (1987), Chu et al., Science 235, 567-(1987), Chu et al., Phys. Rev. Lett. 58, 405(1987), Cava et al., Phys. Rev. Lett. 58, 408 (1987), Bednorz et al., Europhys. Lett. 3,379(1987)]. The superconducting phase has been identified as the composition La1-x(Ba,Sr,Ca)xCu04-y with the tetragonal K2NiF4-type structure and with x typically about 0.15 and y indicating oxygen vacancies.

Wu et al., Phys. Rev. Lett. 58, 908(1987), disclose a superconducting phase in the Y-Ba-Cu-0 system with a superconducting transition temperature of about 90 K. Cava et al., Phys. Rev. Lett. 58, 1676 (1987), have identified this superconducting Y-Ba-Cu-0 phase to be orthorhombic, distorted, oxygen-deficient perovskite YBa2Cu3O9-d where d is about 2.1 and present the powder x-ray diffraction pattern and lattice parameters.

C. Michel et al., Z. Phys. B - Condensed Matter 68, 421(1987), disclose a novel family of superconducting oxides in the Bi-Sr-Cu-O system with composition close to Bi2Sr2Cu2O7+d. A pure phase was isolated for the composition Bi2Sr2Cu2O7+d. The X-ray diffraction pattern for this material exhibits some similarity with that of perovskite and the electron diffraction pattern shows the perovskite subcell with the orthorhombic cell parameters of a = 5.32 A (0.532 nm), b = 26.6 A (2.66 nm) and c = 48.8A (4.88 nm). The material made from ultrapure oxides has a superconducting transition with a midpoint of 22 K as determined from resistivity measurements and zero resistance below 14 K. The material made from commercial grade oxides has a superconducting transition with a midpoint of 7 K.

H. Maeda et al., Jpn. J. Appl. Phys. 27, L209 (1988), disclose a superconducting oxide in the Bi-Sr-Ca-Cu-O system with the composition near BiS- rCaCu2Ox and a superconducting transition temperature of about 105K.

The commonly assigned application, "Superconducting Metal Oxide Compositions and Process For Making Them", S. N. 153,107, filed Feb 8, 1988, a continuation-in-part of S. N. 152,186, filed Feb. 4, 1988, disclose superconducting compositions having the nominal formula BiaSrbCacCu30x wherein a is from about 1 to about 3, b is from about 3/8 to about 4, c is from about 3/16 to about 2 and x = (1.5 a + b + c + y) where y is from about 2 to about 5, with the proviso that b + c is from about 3/2 to about 5, said compositions having superconducting transition temperatures of about 70 K or higher. It also discloses the superconducting metal oxide phase having the formula Bi2Sr3-zCazCu208+w wherein z is from about 0.1 to about 0.9, preferably 0.4 to 0.8 and w is greater than zero but less than about 1. M. A. Subramanian et al., Science 239, 1015(1988) also disclose the Bi2Sr3-zCazCu2O8 + w superconductor.

Y. Yumada et al., Jpn. J. Appl. Phys. 27, L996 (1988), disclose the substitution of Pb for Bi in the series Bi1-xPbxSrCaCu20y where x = 0, 0.1, 0.3, 0.5, 0.7, 0.9 and 1.0. The Tc increases from 75.5 K for x = 0, no Pb present, to a maximum of 85.5 K for x = 0.5. Tc decreases for higher Pb content to 76 K for x = 0.7. No superconductivity was observed for the samples with x = 0.9 and x = 1.

M. Takano et al., Jpn. J. App. Phys. 27, L1041 (1988), disclose that partial substitution of Pb for Bi in the Bi-Sr-Ca-Cu-O system results in an increase in the volume fraction of the high Tc phase. Coprecipitated oxalates containing the relevant ions in various ratios underwent thermal decomposition below 773 K. The samples in powder form were then heated in air to 1073 K for 12 hours and, after being formed into pellets, at 1118 K for various periods which extended to more than 240 hours in some cases. A starting composition of Bi:Pb:Sr:Ca:Cu = 0.7:0.3:1:1:1:8 was heated at 1118 K for 244 hours. The high-Tc phase shows an onset of superconductivity at around 115 K. This phase forms plate-like crystals and analysis of these crystals indicates that the cationic ratio is Bi:Pb:Sr:Ca:Cu = 67:5:100:85:180 so that there is considerably less Pb in the high-Tc than in the starting material.

M. Mizuno et al., Jpn. J. Appl. Phys. 27, L1225 (1988), also disclose that the addition of Pb to the Bi-Sr-Ca-Cu-O system results in an increase in the volume fraction of the high-Tc phase and a lowering of the optimum temperature to obtain this phase to about 855 _{°} C.

E. V. Sampathkumaran et al., J. Phys. F: Met. Phys. 18, L163 (1988) disclose that the partial substitution of K or Pb for Bi in the Bi4Ca3Sr3Cu4O4 results in an enhancement of the fraction of the phase superconducting at about 110 K.

Z. Z. Sheng et al., Nature 332, 55(1988) disclose superconductivity in the TI-Ba-Cu-O system in samples which have nominal compositions TI2Ba2Cu308+x and TIBaCu305.5+x. Both samples are reported to have onset temperatures above 90 K and zero resistance at 81 K. The samples were prepared by mixing and grinding appropriate amounts of BaC03 and CuO with an agate mortar and pestle. This mixture was heated in air at 925 ° C for more than 24 hours with several intermediate grindings to obtain a uniform black oxide Ba-Cu oxide powder which was mixed with an appropriate amount of T1203, completely ground and pressed into a pellet with a diameter of 7 mm and a thickness of 1-2 mm. The pellet was then put into a tube furnace which had been heated to 880-910° C and was heated for 2-5 minutes in flowing oxygen. As soon as it had slightly melted, the sample was taken from the furnace and quenched in air to room temperature. It was noted by visual inspection that T1203 had partially volatilized as black smoke, part had become a light yellow liquid, and part had reacted with Ba-Cu oxide forming a black, partially melted, porous material.

Z. Z. Sheng et al., Nature 332, 138 (1988) disclose superconductivity in the TI-Ca-Ba-Cu-O system in samples which have nominal compositions TI2Ca2BaCu3O9+x with onset of superconductivity at 120K.

R. M. Hazen et al., Phys. Rev. Lett. 60, 1657-(1988), disclose two superconducting phases in the TI-Ba-Ca-Cu-O system, TI2Ba2Ca2Cu3O10 and T12Ba2CaCu208, both with onset of superconductivity near 120 K. C. C. Torardi et al., Science 240, 631(1988) disclose the preparation of TI2Ba2Ca2Cu3O10 with an onset of superconductivity of 125 K.

S. S. P. Parkin et al., Phys. Rev. Lett. 61,750-(1988), disclose the structure TIBa2Ca2Cu3O9±y with transition temperatures up to 11 OK.

M. Hervieu et al., J. Solid State Chem. 75, 212-(1988), disclose the oxide TIBa2CaCu2O8-y.

C. C. Torardi et al., Phys. Rev. B 38, 225-(1988), disclose the oxide TI2Ba2CuO6 with an onset of superconductivity at about 90 K.

The commonly assigned application, "Superconducting Metal Oxide Compositions and Processes For Manufacture and Use", S. N. 236,088, filed Aug. 24,1988, a continuation-in-part of S. N. 230,636, filed Aug. 10, 1988, disclose superconducting compositions having the nominal formula TIePbaCabSrcCudOx wherein a is from about 1/10 to about 3/2, b is from about 1 to about 4, c is from about 1 to about 3, d is from about 1 to about 5, e is from about 3/10 to about 1 and x = (a + b + c + d + e + y) where y is from about 1/2 to about 3. These compositions have an onset of superconductivity of at least 70 K.

J. M. Liang et al., Appl. Phys. Lett. 53, 15-(1988) disclose a composition TIBa2Ca3Cu4Ox with an onset of superconductivity at 155 K and a zero resistance at 123 K. CaC03, BaC03 and CuO powders were ground together and calcined for 15 hours with intermediate grindings. The Ba-Ca-Cu-O powders were mixed with T1203 to yield a mixture with nominal composition TIBaCa3Cu3Ox. This mixture was ground, pressed and sintered for 15 minutes in flowing 02. Composition ratios of the TI:Ca:Ba:Cu in the superconductor vary from 1:2:2:3 to 1:2:3:4.

### SUMMARY OF THE INVENTION

This invention provides novel superconducting compositions in the Pb-R-Ca-Sr-Cu-O system where R is one or more elements selected from the group consisting of yttrium and the rare earth metals, sometimes referred to as "lanthanides", with atomic numbers of 57 to 71. In particular, novel superconducting compositions of this invention have the nominal formula PbₐR_{b}Ca_{c}Sr_{d}CuₑOₓ wherein a is from 1/2 to 5, b is from 1/10 to 2, c is from 1/2 to 4, d is from 1/2 to 4, e is from 3 to 6 and x = (a + b + c + d + e + y) where y is from 1/2 to 3. Preferably, a is from 2 to 4, b is from 1/2 to 1, c is from 3/2 to 4, d is from 3/2 to 4, e is from 3 to 6 and x = (a + b + c + d + e + y) where y is from 1/2 to 3; preferably R is one or more of yttrium, erbium or lutetium. The onset of superconductivity for these compositions is at least 50 K.

These superconducting compositions are prepared by heating a mixture of the Pb, R, Ca, Sr and Cu oxides, the relative amounts chosen so that the atomic ratio Pb:R:Ca:Sr:Cu is a:b:c:d:e, at a temperature of about 900 °C to about 950 °C for about 3 or more hours in a confined atmosphere, e. g., in a sealed tube made of a non-reacting metal such as gold which prevents any of the reactants including the metals and oxygen from escaping.

### BRIEF DESCRIPTION OF THE DRAWINGS

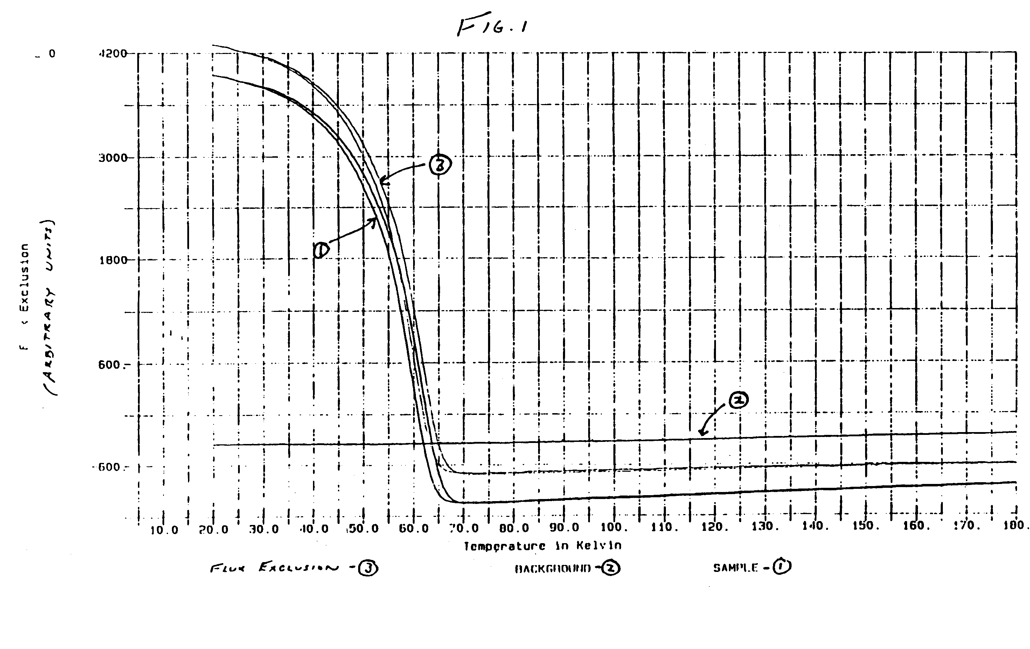

FIG. 1 shows a plot of the flux excluded by a composition of this invention as a function of temperature.

### DETAILED DESCRIPTION OF THE INVENTION

The superconducting compositions of this invention can be prepared by the following process. Quantities of the oxide reactants Pb0₂, R₂0₃, Ca0₂, Sr0₂ and CuO are chosen with the atomic ratio of Pb:R:Ca:Sr:Cu of a:b:c:d:e wherein a is from about 1/2 to about 5, b is from about 1/10 to about 2, c is from about 1/2 to about 4, d is from about 1/2 to about 4, e is from about 3 to about 6, and mixed, for example, by grinding them together in a mortar. The mixed powder may then be heated directly or it can be first formed into a pellet or other shaped object and then heated. The superconducting composition of this invention is produced only when the atmosphere in which the reactants are heated is carefully controlled. One way to accomplish this controlled atmosphere is to place the reactants in a tube made of a non-reacting metal such as gold and then sealing the tube by welding. The sealed tube is then placed in a furnace and heated to about 900 °C to about 950 ° C for about 3 or more hours. The sample is then cooled to room temperature, about 20° C. Typically, cooling can be accomplished by lowering the temperature at a rate about 1-5°C per minute to 300 _{°} C and then removing the tube from the furnace. In one convenient mode of cooling, the power to the furnace is turned off and the tube is furnace-cooled to ambient temperature and then removed from the furnace. The tube is then opened and the black product recovered. The compositions prepared in this manner exhibit the onset of superconductivity above 50 K.

Superconductivity can be confirmed by observing magnetic flux exclusion, i.e., the Meissner effect. This effect can be measured by the method described in an article by E. Polturak and B. Fisher in Physical Review B, 36, 5586(1987).

The superconducting compositions of this invention can be used to conduct current extremely efficiently or to provide a magnetic field for magnetic imaging for medical purposes. Thus, by cooling the composition in the form of a wire or bar to a temperature below the superconducting transition temperature, (T_{c}), in a manner well known to those in this field; and initiating a flow of electrical current, one can obtain such flow without any electrical resistive losses. To provide exceptionally high magnetic fields with minimal power losses, the wire mentioned previously could be wound to form a coil which would be cooled to a temperature below the superconducting transition temperature before inducing any current into the coil. Such fields can be used to levitate objects as large as rail-road cars. These superconducting compositions are also useful in Josephson devices such as SQUIDS (superconducting quantum interference devices) and in instruments that are based on the Josephson effect such as high speed sampling circuits and voltage standards.

### EXAMPLES OF THE INVENTION

### EXAMPLE 1

4.7838 g of Pb0₂, 0.5646 g of Y₂0₃, 1.0812 g of Ca0₂, 2.3924 g of Sr0₂ and 2.3862 g of CuO, corresponding to a Pb:Y:Ca:Sr:Cu atomic ratio of 2:1/2:3/2:2:3, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 900 ° C and then held at 900 ° C for 12 hours. Power to the furnace was then shut off and the tube was allowed to cool to room temperature, about 20 °C, in the furnace. The tube was then removed from the furnace and cut open. The black product was recovered.

Meissner effect measurements showed the onset of superconductivity at about 67 K.

### EXAMPLE 2

7.1757 g of Pb0₂, 0.5645 g of Y₂0₃, 1.0812 g of Ca0₂, 2.3924 g of Sr0₂ and 2.3862 g of CuO, corresponding to a Pb:Y:Ca:Sr:Cu atomic ratio of 4:1/2:3/2:2:3, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 900 ° C and then held at 900 ° C for 12 hours. The sample was then cooled at a rate of 5° C per minute to 300 _{°} C and then removed from the furnace. The tube was allowed to cool to room temperature and then cut open. The black product was recovered.

Meissner effect measurements showed the onset of superconductivity at about 60 K.

### EXAMPLE 3

Two other pellets of the mixed powder of Example 2 were loaded into a gold tube (3/8" dia and 4" long) and the tube was sealed by welding both ends. The tube was placed in a furnace and heated at a rate of 5° C per minute to 925 ° C and then held at 925 ° C for 6 hours. The sample was then cooled at a rate of 1 _{°} C per minute to 300 _{°} C and then removed from the furnace. The tube was allowed to cool to room temperature and then cut open. The black product was recovered.

Meissner effect measurements showed the onset of superconductivity at about 71 K.

### EXAMPLE 4

Two other pellets of the mixed powder of Example 2 were loaded into a gold tube (3/8" dia and 4" long) and the tube was sealed by welding both ends. The tube was placed in a furnace and heated at a rate of 5° C per minute to 950 ° C and then held at 950 ° C for 6 hours. The sample was then cooled at a rate of 1 _{°} C per minute to 300 _{°} C and then removed from the furnace. The tube was allowed to cool to room temperature and then cut open. The black product was recovered.

Meissner effect measurements showed the onset of Superconductivity at about 67 K.

### EXAMPLE 5

4.7838 g of Pb0₂, 0.5645 g of Y₂0₃, 2.1624 g of Ca0₂, 2.3924 g of Sr0₂ and 3.1816 g of CuO, corresponding to a Pb:Y:Ca:Sr:Cu atomic ratio of 2:1/2:3:2:4, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 900 ° C and then held at 900 ° C for 12 hours. The sample was then cooled at a rate of 5° C per minute to 300 _{°} C and then removed from the furnace. The tube was allowed to cool to room temperature and then cut open. The black product was recovered.

Meissner effect measurements showed the onset of superconductivity at about 55 K.

### EXAMPLE 6

Two other pellets of the mixed powder of Example 5 were loaded into a gold tube (3/8" dia and 4" long) and the tube was sealed by welding both ends. The tube was placed in a furnace and heated at a rate of 5° C per minute to 925 ° C and then held at 925 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 65 K.

### EXAMPLE 7

Two other pellets of the mixed powder of Example 5 were loaded into a gold tube (3/8" dia and 4" long) and the tube was sealed by welding both ends. The tube was placed in a furnace and heated at a rate of 5 ° C per minute to 950 ° C and then held at 950 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 56 K.

### EXAMPLE 8

4.7838 g of Pb0₂, 1.1290 g of Y₂0₃, 2.1624 g of Ca0₂, 2.3924 g of Sr0₂ and 3.9770 g of CuO, corresponding to a Pb:Y:Ca:Sr:Cu atomic ratio of 2:1:3:2:5, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 900 ° C and then held at 900 ° C for 12 hours. The sample was then cooled at a rate of 5° C per minute to 300 _{°} C and then removed from the furnace. The tube was allowed to cool to room temperature and then cut open. The black product was recovered.

Meissner effect measurements showed the onset of superconductivity at about 57 K.

### EXAMPLE 9

Two other pellets of the mixed powder of Example 8 were loaded into a gold tube (3/8" dia and 4" long) and the tube was sealed by welding both ends. The tube was placed in a furnace and heated at a rate of 5° C per minute to 925 ° C and then held at 925 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 55 K.

### EXAMPLE 10

Two other pellets of the mixed powder of Example 8 were loaded into a gold tube (3/8" dia and 4" long) and the tube was sealed by welding both ends. The tube was placed in a furnace and heated at a rate of 5° C per minute to 950 ° C and then held at 950 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 61 K.

### EXAMPLE 11

9.5676 g of Pb0₂, 1.1290 g of Y₂0₃, 2.8832 g of Ca0₂, 2.3924 g of Sr0₂ and 4.7724 g of CuO, corresponding to a Pb:Y:Ca:Sr:Cu atomic ratio of 4:1:4:2:6, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 900 ° C and then held at 900 ° C for 12 hours. The sample was then cooled at a rate of 5° C per minute to 300 _{°} C and then removed from the furnace. The tube was allowed to cool to room temperature and then cut open. The black product was recovered.

Meissner effect measurements showed the onset of superconductivity at about 55 K.

### EXAMPLE 12

Two other pellets of the mixed powder of Example 11 were loaded into a gold tube (3/8" dia and 4" long) and the tube was sealed by welding both ends. The tube was placed in a furnace and heated at a rate of 5° C per minute to 925 ° C and then held at 925 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 58 K.

### EXAMPLE 13

Two other pellets of the mixed powder of Example 11 were loaded into a gold tube (3/8" dia and 4" long) and the tube was sealed by welding both ends. The tube was placed in a furnace and heated at a rate of 5° C per minute to 950 ° C and then held at 950 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 59 K.

### EXAMPLE 14

9.5676 g of Pb0₂, 0.5645 g of Y₂0₃, 1.0812 g of Ca0₂, 2.3924 g of Sr0₂ and 2.3862 g of CuO, corresponding to a Pb:Y:Ca:Sr:Cu atomic ratio of 4:1/2:3/2:2:3, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 925 ° C and then held at 925 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 62 K.

### EXAMPLE 15

Two other pellets of the mixed powder of Example 14 were loaded into a gold tube (3/8" dia and 4" long) and the tube was sealed by. welding both ends. The tube was placed in a furnace and heated at a rate of 5° C per minute to 950 ° C and then held at 950 ° C for 6 hours. The sample was then cooled at a rate of 1 _{°} C per minute to 300 ° C and then removed from the furnace. The tube was allowed to cool to room temperature and then cut open. The black product was recovered.

Meissner effect measurements showed the onset of superconductivity at about 65 K.

### EXAMPLE 16

4.7838 g of Pb0₂, 0.9563 g of Er₂0₃, 1.0812 g of Ca0₂, 2.3924 g of Sr0₂ and 2.3862 g of CuO, corresponding to a Pb:Er:Ca:Sr:Cu atomic ratio of 2:1/2:3/2:2:3, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 950 ° C and then held at 950 ° C for 12 hours. The sample was then cooled at a rate of 1 _{°} C per minute to 300 ° C and then removed from the furnace. The tube was allowed to cool to room temperature and then cut open. The black product was recovered.

Meissner effect measurements were carried out and the results are shown in Fig. 1 where the flux exclusion is plotted as a function of temperature. The plot shows the onset of superconductivity at about 67 K.

### EXAMPLE 17

4.7838 g of Pb0₂, 0.9563 g of Lu₂O₃ , 1.0812 g of Ca0₂, 2.3924 g of Sr0₂ and 2.3862 g of CuO, corresponding to a Pb:Lu:Ca:Sr:Cu atomic ratio of 2:1/2:3/2:2:3, were ground together in an agate mortar for about 30 minutes. Pellets, 10 mm in diameter and about 3 mm thick, were pressed from this mixed powder. Two pellets were loaded into a gold tube (3/8" dia and 4" long) and the tube was sealed by welding both ends. The tube was placed in a furnace and heated at a rate of 5_{°}C per minute to 950 ° C and then held at 950 ° C for 12 hours. The sample was then cooled at a rate of 1 _{°} C per minute to 300 _{°} C and then removed from the furnace. The tube was allowed to cool to room temperature and then cut open. The black product was recovered.

Meissner effect measurements showed the onset of superconductivity at about 62 K.

## Claims

1. A superconducting composition having the nominal formula 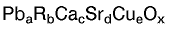 wherein R is one or more elements selected from the group consisting of yttrium and the lanthanides with atomic numbers 57 to 71,
a is from 1/2 to 5,
b is from 1/10 to 4,
c is from 1/2 to 4,
d is from 1/2 to 4,
e is from 3 to 6,
x = (a + b + c + d + e + y) where
y is from 1/2 to 3,
said composition having a superconducting transition temperature of at least 50 K.

2. A superconducting composition as in Claim 1 wherein "a" is 2 to 4, "b" is 1/2 to 1, "c" is 3/2 to 4, "d" is from 3/2 to 4, "e" is 3 to 6 and "y" is from 1/2 to 3.

3. A superconducting composition as in Claim 1 wherein R is at least one element selected from the group consisting of yttrium, erbium and lutetium.

4. A process for making superconducting compositions consisting essentially of mixing stoichiometric quantities of oxides of Pb, R, Ca, Sr and Cu to provide the composition of Claim 1; heating the mixture in a sealed gold tube to a temperature of about 900 _{°} C to about 950 _{°} C and maintaining said temperature for about 3 or more hours to form said composition; and cooling said composition.

5. A process as in Claim 4 wherein the stoichiometric quantities of the oxides are selected to provide the composition of Claim 2.

6. A method for conducting an electrical current within a conductor material without electrical resistive losses comprising the steps of:
cooling a conductor material composed of a composition of Claim 1 to a temperature below the T_{c} of said composition; and
initiating a flow of electrical current within said conductor material while maintaining said material below said temperature.

7. Josephson-effect device wherein the superconductive material comprises the composition of Claim 1.

## Patentansprüche

1. Supraleitende Zusammensetzung der nominalen Formel 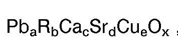 worin
R ein oder mehrere Elemente bezeichnet, die aus der aus Yttrium und der Lanthaniden mit den Atomzahlen 57 bis 71 bestehenden Gruppe ausgewählt sind,
a 1/2 bis 5 ist,
b 1/10 bis 4 ist,
c 1/2 bis 4 ist,
d 1/2 bis 4 ist,
e 3 bis 6 ist,
x = (a + b + c + d + e + y), worin y 1/2 bis 3 ist,
wobei die Zusammensetzung eine Übergangstemperatur der Supraleitung von wenigstens 50 K hat.

2. Supraleitende Zusammensetzung nach Anspruch 1, worin
a 2 bis 4 ist,
b 1/2 bis 1 ist,
c 3/2 bis 4 ist,
d 3/2 bis 4 ist,
e 3 bis 6 ist und
y 1/2 bis 3 ist.

3. Supraleitende Zusammensetzung nach Anspruch 1, worin R wenigstens ein Element ist, das aus der aus Yttrium, Erbium und Lutetium bestehenden Gruppe ausgewählt ist.

4. Verfahren zur Herstellung supraleitender Zusammensetzungen, bestehend im wesentlichen aus
dem Vermischen stöchiometrischer Mengen der Oxide von Pb, R, Ca, Sr und Cu zur Bereitstellung der Zusammensetzung nach Anspruchs 1,
dem Erhitzen der Mischung in einem verschlossenen Gold-Rohr auf eine Temperatur von etwa 900 _{°} C bis etwa 950 _{°} C und
dem Aufrechterhalten dieser Temperatur über etwa 3 oder mehr Stunden zur Bildung der Zusammensetzung und dem Abkühlen der Zusammensetzung.

5. Verfahren nach Anspruch 4, worin die stöchiometrischen Mengen der Oxide so gewählt werden, daß die Zusammensetzung nach Anspruch 2 erhalten wird.

6. Verfahren zum Leiten eines elektrischen Stromes innerhalb eines Leiter-Materials ohne elektrische Widerstands-Verluste, umfassend die Schritte
des Abkühlens eines aus einer Zusammensetzung des Anspruchs 1 bestehenden Leiter-Materials auf eine Temperatur unterhalb von T_{c} der Zusammensetzung und
des Veranlassens eines elektrischen Stromflusses im Inneren des Leiter-Materials, während dieses Material unterhalb der angegebenen Temperatur gehalten wird.

7. Josephson-Effekt-Vorrichtung, worin das supraleitende Material die Zusammensetzung des Anspruchs 1 umfaßt.

## Revendications

1. Composition supraconductrice ayant la formule nominale PbₐR_{b}Ca_{c}Sr_{d}CuₑOₓ, où R est un ou plusieurs éléments choisis dans le groupe constitué de l'yttrium et des lanthanides avec les numéros atomiques 57 à 71,
a est de 1/2 à 5,
b est de 1/10 à 4,
c est de 1/2 à 4,
d est de 1/2 à 4,
e est de 3 à 6,
x = (a + b + c + d + e + y), où y est de 1/2 à 3,
ladite composition ayant une température de transition supraconductrice d'au moins 50 K.

2. Composition supraconductrice selon la revendication 1, dans laquelle "a" est 2 à 4, "b" est 1/2 à 1, "c" est 3/2 à 4, "d" est de 3/2 à 4, "e" est 3 à 6 et "y" est de 1/2 à 3.

3. Composition supraconductrice selon la revendication 1, dans laquelle R est au moins un élément choisi dans le groupe constitué de l'yttrium, de l'erbium et du lutétium.

4. Procédé pour préparer des compositions supraconductrices, consistant essentiellement en le mélange de quantités stoechiométriques d'oxydes de Pb, R, Ca, Sr et Cu pour fournir la composition selon la revendication 1 le chauffage du mélange, dans un tube en or clos, à une température d'environ 900 _{°} C à environ 950 ° C, et le maintien de ladite température pendant environ 3 h ou plus pour former ladite composition ; et le refroidissement de ladite composition.

5. Procédé selon la revendication 4, dans lequel les quantités stoechiométriques des oxydes sont choisies pour fournir la composition selon la revendication 2.

6. Procédé pour conduire un courant électrique dans une matière conductrice, sans pertes électriques résistives, comprenant les étapes de :
refroidissement d'une matière conductrice composée d'une composition selon la revendication 1 à une température inférieure à la T_{c} de ladite composition ; et
passage d'un flux de courant électrique dans ladite matière conductrice tout en maintenant ladite matière en dessous de ladite température.

7. Dispositif à effet Josephson, dans lequel la matière supraconductrice comprend la composition selon la revendication 1.
